Europäisches Patentamt

European Patent Office

Office européen des brevets

(19)

(11) Veröffentlichungsnummer : **0 141 933**
**B1**

(12)

# EUROPÄISCHE PATENTSCHRIFT

(45) Veröffentlichungstag der Patentschrift :
02.11.89

(51) Int. Cl.⁴ : **H 03 B   5/12**, H 03 B   5/36

(21) Anmeldenummer : 84109769.4

(22) Anmeldetag : 16.08.84

(54) Integrierbare Oszillatorschaltung.

(30) Priorität : 15.09.83 DE 3333402

(43) Veröffentlichungstag der Anmeldung :
22.05.85 Patentblatt 85/21

(45) Bekanntmachung des Hinweises auf die Patenterteilung : 02.11.89 Patentblatt 89/44

(84) Benannte Vertragsstaaten :
AT DE FR GB IT NL

(56) Entgegenhaltungen :
CH--D-- 1 384 974
FR--A-- 2 116 482
GB--A-- 2 043 378
PATENTS ABSTRACTS OF JAPAN, Band 6, Nr. 28 (E-
95) [906], 19. Februar 1982; & JP - A - 56 149 104
(NIPPON DENKI K.K.) 18.11.1981
Idem
Idem

(73) Patentinhaber : Siemens Aktiengesellschaft
Wittelsbacherplatz 2
D-8000 München 2 (DE)

(72) Erfinder : Fenk, Josef, Dipl.-Ing.
Deutenhauser Strasse 10
D-8057 Eching/Ottenburg (DE)
Erfinder : Stepp, Richard, Dipl.-Ing.
Elisabethstrasse 25
D-8000 München 40 (DE)

## Beschreibung

Die Erfindung hat die Aufgabe, eine Schaltung für einen symmetrischen und integrierbaren Oszillator anzugeben, der mit hoher Frequenzkonstanz und kleiner Schwingamplitude arbeitet. Als weitere Aufgabe ist die Schaffung eines FM-modulierbaren Oszillators zu verzeichnen, für dessen Aufbau keine Kapazitätsdioden benötigt werden.

Die vorstehend genannte Aufgabe wird bei einer gattungsgemäßen Oszillatorschaltung durch die kennzeichnenden Merkmale des Patentanspruches 1 gelöst.

Ausgestaltungen des Erfindungsgedankens sind in Unteransprüchen gekennzeichnet.

Zur Lösung der genannten Probleme wird eine Schaltung angegeben, die von den bekannten Schaltungen abweicht und die mit einem Minimum an schaltungstechnischem Aufwand zum Ziele gelangt.

Eine beispielsweise durch Patent Abstracts of Japan, Band 6, Nr. 28 (E-95), 19. Februar 1982 (Dokument 1) bekannte und aus Bipolartransistoren vom gleichen Leitfähigkeitstyp und Widerständen bestehende integrierbare bipolare Oszillatorschaltung ist dadurch bekennzeichnet, daß am Anschluß für das Bezugspotential die Fußpunkte von zwei Widerständen und einer Konstantstromquelle liegen, daß dabei der erste Widerstand mit dem Emitter eines ersten Transistors und mit der Basis eines zweiten Transistors sowie der zweite Widerstand mit dem Emitter eines dritten Transistors und der Basis eines vierten Transistors verbunden ist, daß dabei der Emitter des zweiten Transistors und der Emitter des vierten Transistors am Ausgang der Konstantstromquelle liegen, daß weiterhin der Kollektor des ersten Transistors und der Kollektor des dritten Transistors unmittelbar am Anschluß für das Versorgungspotential liegen, während der Kollektor des zweiten Transistors und der Kollektor des vierten Transistors unter Vermittlung je eines Widerstandes an den Anschluß für das Versorgungspotential angeschlossen sind, daß außerdem die Basis des ersten Transistors über einen Widerstand mit dem Kollektor des vierten Transistors und die Basis des dritten Transistors über einen weiteren Widerstand mit dem Kollektor des vierten Transistors verbunden ist und daß schließlich zwischen der Basis des ersten Transistors und der Basis des dritten Transistors ein frequenzbestimmendes Glied, z. B. ein Schwingkreis, einfügbar ist.

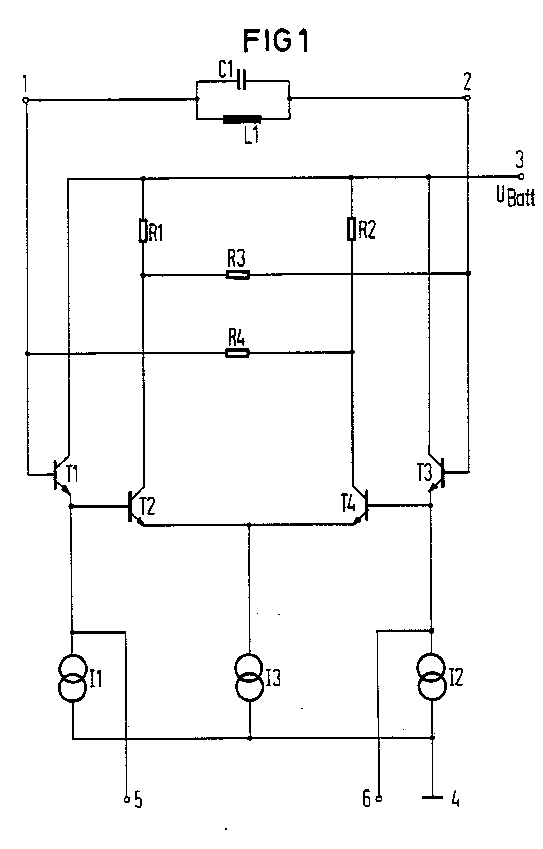

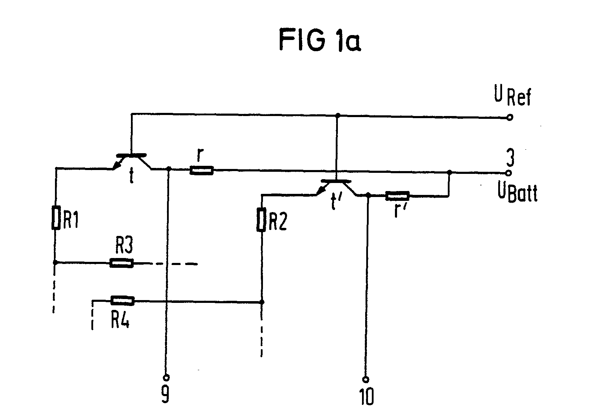

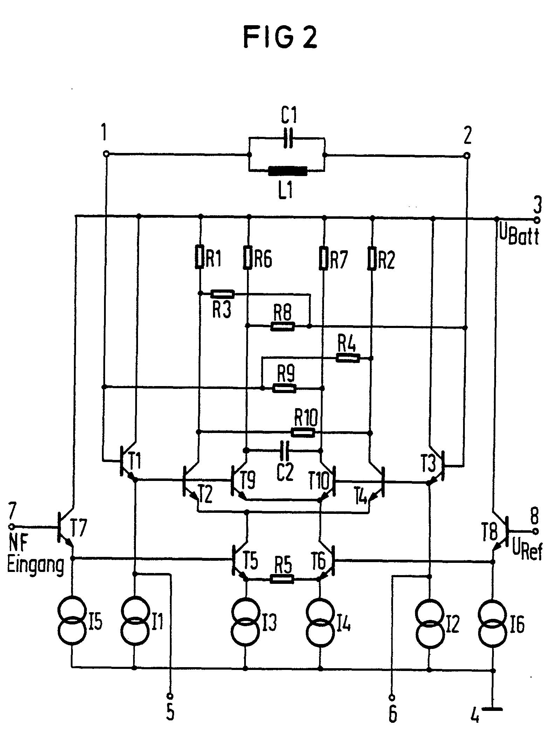

Eine entsprechende Schaltung für einen bekannten Oszillator ist in Fig. 1 dargestellt, während Fig. 1 a eine erfindungsgemäße Weiterbildung des bekannten Oszillators zeigt. Die in Fig. 2 dargestellte Schaltung ist eine Weiterbildung dieser Schaltung zwecks Erzielung der Möglichkeit einer FM-Modulation.

Bei der in Fig. 1 dargestellten Schaltung des bekannten Oszillators ist der erste Transistor T1 mit seinem Emitter an die Basis des zweiten Transistors T2 und außerdem an den Ausgang einer ersten Konstantstromquelle I1 gelegt, während andererseits ein dritter Transistor T3 an seinem Emitter mit der Basis eines vierten Transistor T4 und außerdem mit dem Ausgang einer zweiten Konstantstromquelle I2 verbunden ist. Der Emitter des zweiten Transistors T2 und der Emitter des vierten Transistors T4 werden gemeinsam durch den Ausgang einer dritten Konstantstromquelle I3 gespeist. Die Fußpunkte der drei einander gleichen und z. B. durch einen Transistor in Stromquellenschaltung oder durch einen Stromspiegel gegebenen Konstantstromquellen I1, I2 und I3 liegen an der Klemme 4 für das Bezugspotential. Die verwendeten Transistoren T1-T4 sind (ebenso wie die Transistoren in den Konstantstromquellen) gemäß Fig. 1 durch npn-Transistoren gegeben.

Der Kollektor des ersten Transistors T1 als auch der Kollektor des dritten Transistors T3 sind unmittelbar mit der Klemme 3 für das Versorgungspotential $U_{Batt}$ verbunden, während zwischen dem Kollektor des zweiten Transistors T2 und der Klemme 3 sowie zwischen dem Kollektor des vierten Transistors T4 und der Klemme 3 je ein Widerstand R1 bzw. R2 eingefügt ist. Die beiden Widerstände R1 und R2 sind einander gleich. Ferner liegt die Basis des ersten Transistors T1 an einem weiteren Anschluß 1 und die Basis des dritten Transistors T3 an einem weiteren Anschluß 2. Zwischen den beiden Anschlüssen 1 und 2 liegt ein frequenzbestimmendes Glied, d. h. im Beispielsfalle ein Schwingkreis, der aus der Parallelschaltung eines Kondensators C1 und einer Induktivität L1 besteht. Schließlich ist noch auf einen Widerstand R3, der den Kollektor des zweiten Transistors T2 mit der Basis des dritten Transistors T3 und einen weiteren Widerstand R4 hinzuweisen, welcher eine Verbindung zwischen dem Kollektor des vierten Transistors T4 und der Basis des ersten Transistors T1 bildet. Aus Symmetriegründen sind auch die Widerstände R3 und R4 bevorzugt einander gleich. Das Oszillatorsignal ist zwischen dem Emitter des ersten Transistors T1 und dem Emitter des dritten Transistors T3, d. h. an den Ausgängen 5 und 6 abnehmbar.

Somit besteht der Verstärkerteil des gezeigten Oszillators aus den beiden an der zweiten Stromquelle I2 mit ihrem Emitter liegenden Transistoren T2 und T4 (also dem zweiten und dem vierten Transistor) und den beiden Lastwiderständen R1 und R2. Die dritte Stromquelle I3 liefert der Emitterstrom für diese Verstärkerstufe. Die beiden Emitterfolger T1 und T3 steuern die Basisanschlüsse des Verstärkers T2, T4 und erhöhen die Eingangsimpedanz dieser Stufe, so daß der an den Klemmen 1 und 2 angelegte Schwingkreis C1, L1 weniger bedämpft wird, als wenn diese Emitterfolgerstufen T1 und T3 nicht vorhanden wären.

Über die Widerstände R3 und R4 erfolgt eine symmetrische gleichphasige Rückkopplung auf die Verstärkereingänge, die durch die Basisanschlüsse der Transistoren T1 und T3 gegeben sind. Wird an den Anschlüssen 1 und 2 ein Schwingkreis C1, L1 angeschlossen, so schwingt die beschriebene Schaltung annähernd auf der Mittenfrequenz des Schwingkreises, sofern man die Phasendrehung des Verstärkers vernachlässigen kann. Ist die Schwingkreisgüte ausreichend groß, so kann sich eine Schleifenverstärkung $k \geqslant 1$ einstellen. Es wird dann die Schwingung aufrecht erhalten. Die maximale Schwingungsamplitude stell sich über die Begrenzung an der Differenzverstärker-Eigangskennlinie ein. An den Anschlüssen 5 und 6 kann das Oszillatorsignal rückwirkungsarm mit niedrigem Oberwellenanteil entnommen werden.

Sie anhand von Fig. 1 beschriebene symmetrische Oszillatoranordnung kann auch unsymmetrisch umgebildet werden, indem der mit dem Schwingkreis in Kontakt befindliche Anschlußpunkt 1 oder 2 wahlweise kapazitiv auf Masse (also auf das Bezugspotential an dem Anschluß 4) bezogen wird. Dies geschieht durch einen zusätzlichen Kondensator (in den Zeichnungen nicht dargestellt), über den entweder das eine Ende oder das andere Ende des Schwingkreises C1, L1 an Masse gelegt wird. Schließlich kann der Schwingkreis C1, L1 auch durch einen Schwingquarz ersetzt werden.

Wesentlich für den gezeigten Oszillator ist somit, daß

a) der Schwingkreis am hochohmigen Eingang 1, 2 des Verstärkers liegt und die Signalrückführung über ebenfalls hochohmige Rückkopplungswiderstände R3, R4 realisiert wird. Die Bemessung der beiden rückkopplungswiderstände R3 und R4 ist zweckmäßig so, daß die hohe Güte des Schwingkreises nicht unnötig stark bedämpft wird, während die Lastwiderstände R1 und R2 auf einen der jeweiligen Arbeitsfrequenz angepaßten niedrigen Wert eingestellt werden ;

b) die Schwingamplitude auf relativ niedrige Spannungswerte, d. h. ca 200 $mV_{ss}$, am Schwingkreis begrenzt wird, was durch Teilung der Schwingamplitude an den Lastwiderständen R1 R2 über die hochohmigen Rückkopplungswiderstände R3, R4 geschieht ;

c) eine hohe Frequenzstabilität und spektrale Reinheit durch hohe Betriebsgüte des Schwingkreises (Unterdrückung von Oberwellen) erhalten und

d) durch entsprechende Temperaturgradienten des eingeprägten Stroms eine weitgehende Unabhängigkeit der Frequenz der vom Oszillator gelieferten Schwingungen von der Temperatur im normalen Einsatzbereich für integrierte Schaltungen gewährleistet ist.

Die in Fig. 1 dargestellte bekannte Oszillatorschaltung wird erfindungsgemäß in der aus Fig. 1a ersichtlichen Weise ergänzt.

Hierzu wird das dem zweiten Transistor T2 und dem Rückkopplungswiderstand R3 abgewandte Ende des zugehörigen Lastwiderstandes R1 nicht unmittelbar an die Klemme 3 für das Versorgungspotential $U_{Batt}$ angeschlossen. Dasselbe gilt für das dem vierten Transistor T4 und dem Rückkopplungswiderstand R4 abgewandte Ende des Lastwiderstandes R2. Vielmehr ist dann, wie aus Fig. 1a ersichtlich, das besagte Ende von $R^1$ an den Emitter eines Kaskodetransistors t gelegt, der vom gleichen Typ wie die Transistoren T1-T4 ist. Dasselbe gilt für den Kaskodetransistor t', dessen Emitter an dem besagten Ende des anderen Lastwiderstands R2 liegt. Die Basisanschlüsse der beiden Transistoren t und t' werden durch ein gemeinsames Referenzpotential $U_{Ref}$ beaufschlagt, während ihr Kollektor über je einen Widerstand r bzw. r' an die Versorgungsklemme 3 gelegt ist. Der Kollektor der beiden Kaskodetransistoren t bzw. t' ist außerdem an je eine Ausgangsklemme 9 bzw. 10 gelegt. An den beiden Ausgangsklemmen 9 und 10 kann das Oszillatorsignal ebenfalls abgenommen werden.

Wie bereits angedeutet, läßt sich eine der Erfindung entsprechende Oszillatorschaltung zu einem ohne Hilfe von Kapazitätsdioden modulierbaren FM-Oszillator erweitern. Die hierzu erforderlichen Ergänzungen der Schaltung gemäß Fig. 1 (bzw. Fig. 1a) sind aus Fig. 2 ersichtlich. Diese Schaltung wird nun beschrieben und dann ihre Wirkungsweise dargelegt, wobei die Schaltung nach Fig. 1a in Fig. 2 nicht eingezeichnet ist.

Dabei ist zunächst festzustellen, daß — im Gegensatz zu Fig. 1 — die Verbindung zwischen dem Emitter des zweiten Transistors T2 und des vierten Transistors T4 zum Ausgang der dritten Konstantstromquelle I3 keine unmittelbare Verbindung ist, sondern über die Emitter-Kollektorstrecke eines fünften Transistors T5 erfolgt, wobei der Emitter des fünften Transistors T5 am Ausgang der dritten Stromquelle I3 liegt und außerdem über einen fünften Widerstand R5 mit dem Emitter eines sechsten Transistors T6 sowie mit dem Ausgang einer vierten Konstantstromquelle I4 verbunden ist. Dabei wird darauf hingewiesen, daß auch hier die Fußpunkte der vorgesehenen Stromquellen an der Klemme 4 für das Bezugspotential (Masse) liegen.

Eine siebente Anschlußklemme 7 dient als NF-Eingang und ist durch die Basiselektrode eines siebenten Transistors T7 gegeben, dessen Kollektor an der Klemme 3 für das Versorgungspotential $U_{Batt}$ liegt und dessen Emitter am Ausgang einer fünften Stromquelle I5 liegt und außerdem direkt mit der Basis des fünften Transistors T5 verbunden ist. Ein weiterer Anschluß 8, der durch ein Referenzpotential $U_{ref}$ zu beaufschlagen ist, liegt an der Basis eines achten Transistors T8, dessen Kollektor ebenfalls unmittelbar mit der Klemme 3 für das Versorgungspotential verbunden ist und dessen Emitter einerseits an der Basis des sechsten Transistors T6 und andererseits am Ausgang einer sechsten Stromquelle I6 liegt.

Der Kollektor des sechsten Transistors T6 führt unmittelbar zum Emitter zweier weiterer Transistoren T9 und T20, wobei die Basis des neunten Transistors T9 an den Emitter des ersten Transistors T1 und die

3

Basis des zehnten Transistors T10 an den Emitter des dritten Transistors T3 gelegt ist. Ferner besteht zwischen dem Kollektor des neunten Transistors T9 und der Klemme 3 für das Versorgungspotential $U_{Batt}$ eine über einen Lastwiderstand R6 gegebene Verbindung und zwischen dem Kollektor des zehnten Transistors T10 und der Klemme 3 für das Versorungspotential eine durch einen weiteren Lastwiderstand R7 gegebene Verbindung. Schließlich ist zwischen den Kollektoren der beiden Transistoren T9 und T10 wenigstens eine kapazitive Verbindung gegeben, die in dem gezeichneten Beispielsfall aus einem Kondensator C2 besteht. Ein weiterer Widerstand R8 bildet eine Verbindung zwischen dem Kollektor des neunten Transistors T9 und der Basis des dritten Transistors T3. Ebenso ist eine durch einen Widerstand R9 gegebene Verbindung zwischen dem Kollektor des zehnten Transistors T10 und der Basis des ersten Transistors gegeben. Schließlich ist noch ein zehnter Widerstand R10 vorgesehen, über welchen der Kollektor des zweiten Transistors T2 mit dem Kollektor des vierten Transistors T4 verbunden ist.

Wie man aufgrund des in Fig. 2 dargestellten Schaltbildes unmittelbar erkennen kann, besteht der eigentliche Oszillator aus den Transistoren T1, T2, T9, T10, T4, T3, den Widerständen R1-R4 und R6-R9. Er enthält außerdem die Induktivität L1 und den Kondensator C1 des Schwingkreises zwischen den Klemmen 1 und 2 sowie die zwischen den Kollektoren von T9 und T10 liegende Kapazität C2.

Ist nun der Anschluß 7 (= NF-Eingang) wesentlich positiver als der Referenzpunkt (Anschluß 8) und sind die genannten Transistoren wie im gezeichneten Fall alle vom npn-Typ, so fließt von den Stromquellen I3, I4 in T5 und T6 eingeprägte Strom voll über den Kollektor von T5 in die Emitter der emittergekoppelten Differenzverstärkerstufe T2, T4. Somit arbeitet diese Stufe mit maximaler Verstärkung. An den Anschlüssen 1 und 2 liegen die eigentlichen frequenzbestimmenden Elemente C1, L1. Über den Emitter der beiden als Emmitterfolger arbeitenden Transistoren T1, T3 werden die Basisanschlüsse von T2 und T9 bzw. von T4 und T10 angesteuert, wobei unter den soeben genannten Verhältnissen nur die beiden Transistoren T2 und T4 aktiv sind. Das verstärkte Signal liegt an den Widerständen R10 und R1 bzw. R10 und R2 an. Über die Widerstände R3 und R4 wird dieses Signal gleichphasig an die Eingänge 1 und 2 des Verstärkers und damit auf den Schwingkreis C1, L1 zurückgeführt. Hat der Verstärker keine nennenswerte eigene Phasendrehung, so schwingt der Oszillator auf der Mittenfrequenz des Schwingkreises L1, C1, wobei die Schwingamplitude durch die Begrenzung der Differenzverstärker-Eingangskennlinie sowie durch die Schwingkreisgüte bestimmt ist.

An den Anschlüssen 5 und 6, also den Emittern der Transistoren T1 und T3 kann das vom Oszillator gelieferte Signal rückwirkungsarm und mit hoher spektraler Reinheit entnommen werden, da es direkt vom Schwingkreis L1, C1 abgeleitet ist.

Ist nun andererseits das Potential auf dem NF-Eingangsanschluß 7 wesentlich negativer als das Potential am Referenzeingang 8, so fließt der Strom aus den Quellen I3, I4 voll über den Kollektor des Transistors T10 in die zweite emittergekoppelte Differenzverstärkerstufe T9, T10. Der komplexe Lastwiderstand dieser Differenzstufe T9, T10 besteht aus den Widerständen R6, R7 und dem Kondensator C2. Er ist durch entsprechende Einstellung der ihn bildenden Einzelelemente so bemessen, daß er denselben Betrag wie wie der Lastwiderstand an der durch die Transistoren T2 und T4 gebildeten Differenzstufe aufweist. Jedoch ist ein Phasenwinkel, z. B. von —45°, festeingestellt dank der Anwesenheit des Kondensators C2. Für die Schwingbedingung des Oszillators gilt, daß die Übertragungsphase in dem geschlossenen Kreis der Oszillatorschaltung den Wert gleich Null und der normierte Amplitudenwert größer oder gleich Eins ist. Damit die Gesamtphase gleich 0° wird, muß sich eine Schwingfrequenz derart einstellen, daß der Parallelschwingkreis im Phasenverlauf um den Betrag von 45° unterhalb der Resonanzfrequenz liegt. Aufgrund der beschriebenen Verhältnisse erreicht man also, daß durch eine an den Anschluß 7 angelegte Gleichspannung bzw. Wechselspannung die Oszillatorfrequenz verändert und somit eine FM-Modulation möglich ist.

Die Werte für die Widerstände der in Fig. 1 bzw. Fig. 2 dargestellten Schaltung können z. B. wie folgt eingestellt werden :

$$R1 = 2\,k\Omega\,; \quad R2 = 2\,k\Omega\,; \quad R3 = 10\,k\Omega\,; \quad R4 = 10\,k\Omega\,;$$
$$R5 = 4\,k\Omega\,; \quad R6 = 2\,k\Omega\,; \quad R7 = 2\,k\Omega\,; \quad R8 = 10\,k\Omega\,;$$
$$R9 = 10\,k\Omega\,; \quad R10 = 4\,k\Omega\,; \quad r = r' = 2\,k\Omega\,;$$

Für den Kondensator C2 empfiehlt sich ein Kapazitätswert von beispielsweise $C1 = (\omega \cdot R10)^{-1} = 7$ pF für 5,5 MHz.

Anstelle der npn-Transistoren könnten auch pnp-Transistoren verwendet werden. Allerdings ist aus bekannten Gründen die beschriebene Ausführungsform mit npn-Transistoren besser.

Wesentlich an der in Fig. 2 dargestellten Oszillatorschaltung gemäß der Erfindung ist somit :

1) Der Oszillator weist zwei Verstärkerstufen T2, T4 und T9, T10 auf, während die in Fig. 1 dargestellte Grundform der Erfindung nur eine solche Verstärkerstufe, nämlich T2, T4 aufweist. Dadurch ist bei der Oszillatorschaltung nach Fig. 2 eine Frequenzänderung durch Stromsteuerung an diesen beiden Stufen möglich.

2) Die NF-Signaleinspeisung liegt nicht im HF-Signalweg, so daß keine Beeinflussung zwischen dem HF-Weg und dem NF-Weg auftritt.

3) Das FM-modulierte HF-Signal kann rückwirkungsarm an den Anschlüssen 5, 6 (bzw. 9, 10) mit geringem Oberwellenanteil entnommen werden.

4) Die Modulation ist nur mit einem sehr kleinen Modulationsklirrfaktor behaftet.

Man erkennt ohne weiteres, daß sich die Schaltung gemäß Fig. 1 sowie die Schaltung gemäß Figur 2 (höchstens mit Ausnahme des Schwingkreises L1, C1) sich ohne Schwierigkeiten monolithisch integrieren läßt. Schließlich können auch die in der Schaltung verwendeten Transistoren durch Feldeffekttransistoren, insbesondere durch selbstsperrende MOS-Feldeffekttransistoren, z. B. vom n-Kanaltyp, ersetzt werden.

**Patentansprüche**

1. Integrierbare bipolare Oszillatorschaltung, welche aus Transistoren vom gleichen Leitfähigkeitstyp und Widerständen aufgebaut ist, dadurch gekennzeichnet, daß am Anschluß (4) für das Bezugspotential die Fußpunkte von drei Konstantstromquellen (I1, I2, I3) liegen, daß dabei der Ausgang der ersten Konstantstromquelle (I1) mit dem Emitter eines ersten Transistors (T1) und mit der Basis eines zweiten Transistors (T2) sowie der Ausgang der zweiten Konstantstromquelle (I2) mit dem Emitter eines dritten Transistors (T3) und der Basis eines vierten Transistors (T4) verbunden ist, daß dabei der Emitter des zweiten Transistors (T2) und der Emitter des vierten Transistors (T4) am Ausgang der dritten Konstantstromquelle (I3) liegen, daß weiterhin der Kollektor des ersten Transistors und der Kollektor des dritten Transistors unmittelbar am Anschluß (3) für das Versorgungspotential. (U$_{Batt}$) liegen, während der Kollektor des zweiten Transistors (T2) und der Kollektor des vierten Transistors (T4) unter Vermittlung je eines Widerstands (R1, R2) an den Anschluß (3) für das Versorgungspotential angeschlossen sind, daß außerdem die Basis des ersten Transistors (T1) über einen Widerstand (R4) mit dem Kollektor des vierten Transistors (T4) und die Basis des dritten Transistors (T3) über einen weiteren Widerstand (R3) mit dem Kollektor des zweiten Transistors (T2) verbunden ist, daß zwischen der Basis des dritten Transistors (T3) und der Basis des ersten Transistors (T1) ein frequenzbestimmendes Rückkopplungsglied, z. B. ein Schwingkreis, einfügbar und die gelieferte Oszillatorspannung zwischen dem Emitter des ersten Transistors (T1) und dem Emitter des dritten Transistors (T3) abnehmbar ist und daß das Oszillatorsignal mit Hilfe von Kaskodentransistoren (t, t') geliefert wird, indem ein erster Kaskodentransistor (t) mit seinem Emitter an dem vom zweiten Transistor (T2) abgewandten Ende des zum ersten Transistor (T1) gehörenden Lastwiderstands (R1) und ein zweiter Kaskodentransistor (t') mit seinem Emitter an dem vom vierten Transistor (T4) abgewandten Ende des zum vierten Transistor (T4) gehörenden Lastwiderstands (R2) angeschlossen ist und auf diese Weise die einzige Verbindung zwischen dem Lastwiderstand (R1 bzw. R2) und dem Anschluß (3) für das Versorgungspotential gegeben ist, indem die Basisanschlüsse der beiden Kaskodetransistoren (t, t') an ein gemeinsames Referenzpotential (U$_{Ref}$) und der Kollektor der beiden Kaskodetransistoren unter Verwendung je eines Widerstands (r, r') mit dem Anschluß (3) für das Versorgungspotential verbunden ist, so daß zwischen den Kollektoren der beiden Kaskodetransistoren (t, t') das abzunehmende Oszillatorsignal entsteht.

2. Oszillatorschaltung nach Anspruch 1, dadurch gekennzeichnet, daß die Verbindung zwischen dem Emitter des zweiten Transistors (T2) und des vierten Transistors (T4) zum Ausgang der dritten Konstantstromquelle (I3) unter Vermittlung eines fünften Transistors (T5) erfolgt, dessen Emitter am Ausgang der Konstantstromquelle (I3) liegt und dessen Kollektor mit dem Emitter des zweiten Transistors (T2) und des vierten Transistors (T4) verbunden ist, daß außerdem der Emitter des fünften Transistors (T5) über einen fünften Widerstand (R5) einerseits am Emitter eines sechsten Transistors (T6) und andererseits am Ausgang einer mit ihrem Fußpunkt am Bezugspotential (4) liegenden vierten Konstantstromquelle (I4) liegt, daß ferner ein durch ein NF-Signal zu beaufschlagender Eingang (7) durch die Basis eines siebenten Transistors (T7) und ein durch eine Referenzspannung (U$_{Ref}$) zu beaufschlagender achter Eingang (8) durch die Basis eines achten Transistors (T8) gegeben ist, daß dabei der Emitter des siebenten Transistors (T7) am Ausgang einer an den Anschluß (4) für das Bezugspotential mit ihrem Fußpunkt angeschlossenen fünften Konstantstromquelle (I5) und der Emitter des achten Transistors (T8) am Ausgang einer an den Anschluß (4) für das Bezugspotential mit ihrem Fußpunkt angeschlossenen sechsten Konstantstromquelle (I6) liegt, daß weiterhin der Emitter des siebenten Transistors (T7) mit der Basis des fünften Transistors (T5) sowie der Emitter des achten Transistors (T8) mit der Basis des sechsten Transistors (T6) verbunden ist, daß ferner der Kollektor des siebenten Transistors (T7) sowie der Kollektor des achten Transistors (T8) unmittelbar am Anschluß (3) für das Versorgungspotential liegen, während der Kollektor des sechsten Transistors (T6) unmittelbar am Emitter eines neunten Transistors (T9) und am Emitter des zehnten Transistors (T10) liegt, daß außerdem der Kollektor des neunten Transistors (T9) und der Kollektor des zehnten Transistors (T10) über je einen Lastwiderstand (R6 bzw. R7) am Anschluß (3) für das Versorgungspotential liegen und außerdem der Kollektor des neunten Transistors (T9) über einen weiteren Widerstand (R8) mit der Basis des dritten Transistors (T3) sowie der Kollektor des zehnten Transistors (T10) über einen weiteren Widerstand (R9) mit der Basis des ersten Transistors (T1) verbunden ist und daß schließlich zwischen dem Kollektor des neunten Transistors (T9) und dem Kollektor des zehnten Transistors (T10) eine durch wenigstens einen Kondensator (C2) gegebene kapazitive Verbindung und zwischen den Kollektoren des zweiten Transistors (T2) und des vierten Transistors (T4) eine durch einen weiteren widerstand (R10) gegebene Verbindung vorgesehen ist.

3. Oszillatorschaltung nach einem der Ansprüche 1 oder 2, dadurch gekennzeichnet, daß die dabei verwendeten Transistoren durch je einen Feldeffekttransistor, insbesondere einen MOS-Feldeffekttransistor vom selbstsperrenden Typ, ersetzt sind.

## Claims

1. Bipolar integrated circuit oscillator, which is assembled from transistors of the same conductivity type and from resistors, characterized in that the low ends of three constant current sources (I1, I2, I3) are connected to the terminal (4) for the reference voltage, in that in this regard the output of the first constant current source (I1) is connected to the emitter of a first transistor (T1) and to the base of a second transistor (T2), and the output of the second constant current source (I2) is connected to the emitter of a third transistor (T3) and to the base of a fourth transistor (T4), in that in this regard the emitter of the second transistor (T2) and the emitter of the fourth transistor (T4) is connected to the output of the third constant current source (I3) in that, moreover, the collector of the first transistor and the collector of the third transistor are directly connected to the terminal (3) for the supply voltage ($U_{Batt}$), while the collector of the second transistor (T2) and the collector of the fourth transistor (T4) are connected with the interposition of a resistor (R1, R2) in each case to the terminal (3) for the supply voltage, in that furthermore the base of the first transistor (T1) is connected via a resistor (R4) to the collector of the fourth transistor (T4) and the base of the third transistor (T3) is connected via a further resistor (R3) to the collector of the second transistor (T2), in that a frequency-determining feedback element, e.g. an oscillating circuit, can be inserted between the base of the third transistor (T3) and the base of the first transistor (T1), and the oscillator voltage supplied can be tapped between the emitter of the first transistor (T1) and the emitter of the third transistor (T3), and in that the oscillator signal is supplied with the aid of cascode transistors (t, t') by the fact that a first cascode transistor (t) is connected with its emitter to the end of the load resistor (R1) which belongs to the first transistor (T1) and is averted from the second transistor (T2), and that a second cascode transistor (t') is connected with its emitter to the end of the load resistor (R2) which belongs to the fourth transistor (T4) and is averted from the fourth transistor (T4), and that in this way the sole connection between the load resistor (R1 or R2) and the terminal (3) for the supply voltage is provided, by the fact that the base terminals of the two cascode transistors (t, t') are connected to a common reference voltage ($U_{Ref}$), and the collector of the two cascode transistors is connected with the use of a resistor (r, r') in each case to the terminal (3) for the supply voltage, so that the oscillator signal which is to be tapped arises between the collectors of the two cascode transistors (t, t').

2. Oscillator circuit according to Claim 1, characterized in that the connection between the emitter of the second transistor (T2) and of the fourth transistor (T4) to the output of the third constant current source (I3) takes place with the interposition of a fifth transistor (T5), whose emitter is connected to the output of the constant current source (I3) and whose collector is connected to the emitter of the second transistor (T2) and of the fourth transistor (T4) in that furthermore the emitter of the fifth transistor (T5) is connected, on the one hand, via a fifth resistor (R5) to the emitter of a sixth transistor (T6) and, on the other hand, to the output of a fourth constant current source (I4) connected with its low end to the reference voltage (4), in that further an input (7) to which a low-frequency signal is to be applied is provided by the base of a seventh transistor (T7) and an eighth input (8) to which a reference voltage ($U_{Ref}$) is to be applied is provided by the base of an eighth transistor (T8) in that in this regard the emitter of the seventh transistor (T7) is connected to the output of a fifth constant current source (I5) connected with its low point to the terminal (4) for the reference voltage, and the emitter of the eighth transistor (T8) is connected to the output of a sixth constant current source (I6) connected with its low point to the terminal (4) for the reference voltage, in that moreover the emitter of the seventh transistor (T7) is connected to the base of the fifth transistor (T5), and the emitter of the eighth transistor (T8) is connected to the base of the sixth transistor (T6), in that further the collector of the seventh transistor (T7) and the collector of the eighth transistor (T8) are directly connected to the terminal (3) for the supply voltage, while the collector of the sixth transistor (T6) is directly connected to the emitter of a ninth transistor (T9) and to the emitter of the tenth transistor (T10), in that further the collector of the ninth transistor (T9) and the collector of the tenth transistor (T10) are connected in each case via a load resistor (R6 or R7) to the terminal (3) for the supply voltage, and further the collector of a ninth transistor (T9) is connected via a further resistor (R8) to the base of the third transistor (T3) and the collector of the tenth transistor (T10) is connected via a further resistor (R9) to the base of the first transistor (T1), and in that, finally, between the collector of the ninth transistor (T9) and the collector of the tenth transistor (T10) is provided a capacitive connection given by at least one capacitor (C2), and between the collectors of the second transistor (T2) and the fourth transistor (T4) there is provided a connection given by a further resistor (R10).

3. Oscillator circuit according to one of Claims 1 or 2, characterized in that the transistors employed in this regard are replaced in each case by a field-effect transistor, especially an MOS field-effect transistor of self-blocking type.

**Revendications**

1. Circuit oscillateur bipolaire intégrable, constitué par des transistors possédant le même type de conductivité et par des résistances, caractérisé par le fait que les points de base de trois sources de courant constant (I1, I2, I3) sont raccordées à la borne (4) placé au potentiel de référence, que la sortie de la première source de courant constant (I1) est reliée à l'émetteur d'un premier transistor (T1) et à la base d'un second transistor (T2) et que la sortie de la seconde source de courant constant (I2) est reliée à l'émetteur d'un troisième transistor (T3) et à la base d'un quatrième transistor (T4), que l'émetteur du second transistor (T2) et l'émetteur du quatrième transistor (T4) sont raccordés à la sortie de la troisième source de courant (I3), qu'en outre, le collecteur du premier transistor et le collecteur du troisième transistor sont raccordés directement à la borne (3) placée au potentiel d'alimentation (U_Batt), tandis que le collecteur du second transistor (T2) et le collecteur du quatrième transistor (T4) sont raccordés, par l'intermédiaire d'une résistance respective (R1, R2), à la borne (3) placée au potentiel d'alimentation, qu'en outre la base du premier transistor (T1) est reliée par l'intermédiaire d'une résistance (R4) au collecteur du quatrième transistor (T4) et que la base du troisième transistor (T3) est reliée par l'intermédiaire d'une autre résistance (R3) au collecteur du second transistor (T2), qu'un circuit de réaction déterminant la fréquence, par exemple un circuit oscillant, peut être inséré entre la base du troisième transistor (T3) et la base du premier transistor (T1), que la tension délivrée par l'oscillateur peut être prélevée entre l'émetteur du premier transistor (T1) et l'émetteur du troisième transistor (T3) et que le signal de l'oscillateur est délivré par l'intermédiaire de deux transistors cascode (t, t'), par le fait qu'un premier transistor cascode (t) est raccordé, par son émetteur, à l'extrémité, tournée à l'opposé du second transistor (T2), de la résistance de charge (R1) associée au premier transistor (T1), et qu'un second transistor cascode (t') est raccordé, par son émetteur, à l'extrémité, située à l'opposé du quatrième transistor (T4), de la résistance de charge (R2) associée au quatrième transistor (T4), et que de ce fait, la seule liaison entre la résistance de charge (R1 ou R2) et la borne (3) placée au potentiel d'alimentation est prédéterminée grâce au fait que les bornes de base des deux transistors cascode (t, t') sont placées à un potentiel de référence commun (U_Ref) et que le collecteur des deux transistors cascode est relié, moyennant l'utilisation d'une résistance respective (r, r'), à la borne (3) placée au potentiel d'alimentation, de sorte que le signal de l'oscillateur, qui doit être prélevé, apparaît entre les collecteurs des deux transistors cascode (t, t').

2. Circuit oscillateur suivant la revendication 1, caractérisé par le fait que la liaison entre l'émetteur du second transistor (T2) et du quatrième transistor (T4) est raccordée à la sortie de la quatrième source de courant constant (I3) moyennant l'interposition d'un cinquième transistor (T5), dont l'émetteur est relié à la sortie de la source de courant constant (I3) et dont le collecteur est relié à l'émetteur du second transistor (T2) et du quatrième transistor (T4), qu'en outre l'émetteur du cinquième transistor (T5) est raccordé par l'intermédiaire d'une cinquième résistance (R5) d'une part à l'émetteur d'un sixième transistor (T6) et d'autre part à la sortie d'une quatrième source de courant constant (I4), raccordée par son point de base au potentiel de référence (4), qu'en outre, une entrée (7) devant être chargée par un signal à basse fréquence est formée par la base d'un septième transistor (T7) et qu'une huitième entrée (8), devant être chargée par une tension de référence (U_ref) est formée par la base d'un huitième transistor (T8), que l'émetteur du septième transistor (T7) est raccordé à la sortie d'une cinquième source de courant constant (I5), raccordée par son point de. base à la borne (4) placée au potentiel de référence et que l'émetteur du huitième transistor (T8) est raccordé à la sortie d'une sixième source de courant constant (I6) raccordée par son point de base à la borne (4) placée au potentiel de référence, qu'en outre l'émetteur du septième transistor (T7) est reliée à la base du sixième transistor (T5) et que l'émetteur du sixième transistor (T8) est relié à la base du sixième transistor (T6), qu'en outre, le collecteur du sixième transistor (T7) ainsi que le collecteur du huitième transistor (T8) sont raccordés directement à la borne (3) pour le placer au potentiel d'alimentation, tandis que le collecteur du sixième transistor (T6) est raccordé directement à l'émetteur d'un neuvième transistor (T9) et à l'émetteur du dixième transistor (T10), qu'en outre le collecteur du neuvième transistor (T9) et le collecteur du dixième transistor (T10) sont raccordés par l'intermédiaire de résistances respectives de charge (R6 ou R7) à la borne (3) placée au potentiel d'alimentation et qu'en outre le collecteur du neuvième transistor (T9) est relié par l'intermédiaire d'une autre résistance (R8) à la base du troisième transistor (T3) et que le collecteur du dixième transistor (T10) est relié par l'intermédiaire d'une résistance (R9) à la base du premier transistor (T1), et qu'enfin une liaison capacitive formée par au moins un condensateur (C2) est prévue entre le collecteur du neuvième transistor (T9) et le collecteur du dixième transistor (T10), et qu'une liaison formée par une autre résistance (R10) est prévue entre les collecteurs du second transistor (T2) et du quatrième transistor (T4).

3. Circuit oscillateur suivant l'une des revendications 1 ou 2, caractérisé par le fait que les transistors utilisés sont remplacés chacun par un transistor à effet de champ, notamment un transistor à effet de champ MOS du type autobloquant.

7

# FIG 1

# FIG 1a

# FIG 2